# EUROPEAN PATENT APPLICATION

(11) **EP 4 764 680 A1**
(43) Date of publication of application: **24.06.2026**
(21) Application number: 25215543.7
(22) Date of filing: 13.11.2025
(51) Int. Cl.: G02F 1/1333, G02F 1/1345

(54) **ELECTRONIC DEVICE**

(30) Priority: 20.12.2024 JP 2024225215
(71) Applicant: Nintendo Co., Ltd., Kyoto 601-8501 (JP)
(72) Inventor: NISHIDA, Takafumi, Kyoto, 601-8501 (JP); ISHIBASHI, Satoshi, Kyoto, 601-8501 (JP)
(74) Representative: Bardehle Pagenberg Partnerschaft mbB Patentanwälte Rechtsanwälte

(57) **Abstract**

Electronic device includes light guide plate, light source that emits light toward light guide plate, liquid crystal panel facing light guide plate in thickness direction to be illuminated with light from light source transmitted through light guide plate, backplate opposite to liquid crystal panel in thickness direction with light guide plate between backplate and liquid crystal panel, driver component on liquid crystal panel to control display of liquid crystal panel, first wiring board on support surface of backplate, opposite to its surface facing light guide plate in thickness direction, and electrically connected to driver component, second wiring board on support surface of backplate and electrically connected to light source and first wiring board, and thermal conductor on support surface of backplate and covering at least part of second wiring board. At least part of first wiring board is exposed without being covered with thermal conductor.

## Description

### Technical Field

The present disclosure relates to an electronic device including a liquid crystal panel.

### Description of the Background

An electronic device including a liquid crystal panel generates heat during an operation of the panel, such as when the panel displays images. The liquid crystal panel is illuminated with a backlight that generates heat, which may be conducted to other components. Such heat conduction is to be reduced.

A video display device described in Patent Document 1 includes an anisotropic heat-conducting sheet such as a graphite sheet (in other words, a thermal conductor) that conducts heat from the backlight to a heat dissipator to reduce heat conduction to a circuit board.

### PRIOR ART DOCUMENTS

### PATENT DOCUMENTS

Patent Document 1: JP-A-2007-147910

### BRIEF SUMMARY

In the video display device described in Patent Document 1, the thermal conductor is bonded across the entire surface of the video display device behind the backlight. However, the thermal conductor is relatively expensive. The area of the bonded thermal conductor is thus to be minimized.

In response to the above issue, one or more aspects of the present disclosure are directed to an electronic device that can diffuse heat through a thermal conductor with a smaller area.

In response to the above, an electronic device according to one or more aspects of the present disclosure may have, for example, one of the structures according to (1) to (10) below.

(1)
An electronic device according to an aspect of the present disclosure includes a light guide plate, a light source, a liquid crystal panel, a backplate, a driver component, a first wiring board, a second wiring board, and a thermal conductor. The light source emits light toward the light guide plate. The liquid crystal panel faces the light guide plate in a thickness direction to be illuminated with light from the light source transmitted through the light guide plate. The backplate is located opposite to the liquid crystal panel in the thickness direction with the light guide plate located between the backplate and the liquid crystal panel. The driver component is located on the liquid crystal panel to control display of the liquid crystal panel. The first wiring board is located on a support surface of the backplate and electrically connected to the driver component. The support surface is opposite to a surface of the backplate facing the light guide plate in the thickness direction. The second wiring board is located on the support surface of the backplate and electrically connected to the light source and the first wiring board. The thermal conductor is located on the support surface of the backplate and covers at least part of the second wiring board. At least part of the first wiring board is exposed without being covered with the thermal conductor.

With the structure according to (1), at least part of the first wiring board is exposed without being covered with the thermal conductor. The thermal conductor on the support surface thus has a smaller area than when the thermal conductor extends across the entire support surface. Heat diffusion is thus achieved using a thermal conductor with such a smaller area. This structure also avoids the cost increase associated with a thermal conductor with a larger area in the electronic device.

With the structure according to (1), at least part of the second wiring board electrically connected to the light source is covered with the thermal conductor. The heat from the light source can be diffused through the thermal conductor, and is thus less likely to concentrate locally on the liquid crystal panel.

The driver component generates less heat than the light source. The heat conducted from the driver component through the first wiring board is thus less than the heat conducted from the light source through the second wiring board. With the structure according to (1), the thermal conductor at least does not cover part of the first wiring board, which conducts such less heat. This can prevent the thermal conductor from having an excess area.

(2)
In the structure according to (1), the thermal conductor may overlap at least part of the light source when viewed in the thickness direction.

With the structure according to (2), the thermal conductor can easily diffuse heat conducted from the light source in the thickness direction.

(3)
In the structure according to (1) or (2), the thermal conductor may cover no part of the first wiring board.

With the structure according to (3), the thermal conductor on the support surface has a smaller area than when the thermal conductor covers the first wiring board.

(4)
In the structure according to any one of (1) to (3), the light source may be adjacent to the light guide plate in an orthogonal direction orthogonal to the thickness direction, and may be located at an end of the liquid crystal panel in the orthogonal direction when viewed in the thickness direction. The light guide plate may redirect light traveling in the orthogonal direction from the light source to the thickness direction, and guide the light to the liquid crystal panel.

With the structure according to (4), more heat from the light source is locally received at the end of the liquid crystal panel in the orthogonal direction. However, a large portion of the heat from the light source is conducted through the second wiring board to the thermal conductor, which then diffuses the heat. This can reduce local concentration of heat.

(5)
In the structure according to (4), the light source may be located at the end of the liquid crystal panel in the orthogonal direction when viewed in the thickness direction. The driver component may be located at another end of the liquid crystal panel in the orthogonal direction when viewed in the thickness direction.

With the structure according to (5), the light source and the driver component, which both generate heat, are separate from each other. This reduces concentration of heat.

(6)
In the structure according to any one of (1) to (5), the thermal conductor may be a graphite sheet.

With the structure according to (6), the thermal conductor can diffuse heat more efficiently than when, for example, the thermal conductor is a ceramic sheet.

(7)
In the structure according to any one of (1) to (6), the first wiring board on the support surface may have an electronic component mounted on the first wiring board. The second wiring board on the support surface may have no electronic component mounted on the second wiring board.

Any electronic component mounted on the second wiring board may cause unevenness on the second wiring board. The second wiring board with such unevenness cannot be covered with the thermal conductor, possibly reducing the heat diffusion effect of the thermal conductor. With the structure according to (7), such reduction in the heat diffusion effect is less likely to occur, with no electronic component mounted on the second wiring board.

(8)
In the structure according to any one of (1) to (7), the second wiring board on the support surface may be elongated and may extend along the support surface of the backplate.

With the structure according to (8), the area occupied by the second wiring board can be smaller.

(9)
In the structure according to any one of (1) to (8), the electronic device according to an aspect of the present disclosure may further include a housing located opposite to the light guide plate in the thickness direction with the backplate located between the housing and the light guide plate. The housing may have a first opening extending through the housing in the thickness direction. The first wiring board may include a first bend bent in the thickness direction and passing through the first opening.

With the structure according to (9), the first wiring board is routed through the first opening into the housing. This allows the first wiring board to be shorter than when the first wiring board is routed around the outer edge of the housing and then into the housing.

(10)
In a structure according to any one of (1) to (9), the electronic device according to an aspect of the present disclosure may further include a housing located opposite to the light guide plate in the thickness direction with the backplate located between the housing and the light guide plate. The housing may have a second opening extending through the housing in the thickness direction. The first wiring board may include a second bend bent from a first direction to a second direction. The first direction is along the support surface of the backplate, and the second direction is along the support surface of the backplate and intersects with the first direction. The second bend may overlap the second opening when viewed in the thickness direction.

At the second bend of the first wiring board, the first wiring board may be folded to form two layers stacked in the thickness direction. A portion of the first wiring board with such two stacked layers is likely to be deflected in the thickness direction. The deflected first wiring board may press the liquid crystal panel or the housing in the thickness direction. With the structure according to (10), the second bend overlaps the second opening when viewed in the thickness direction. When the second bend is deflected in the thickness direction, the second opening can receive the deflected second bend. The first wiring board is thus less likely to press the liquid crystal panel or the housing in the thickness direction.

The electronic device according to the above aspects of the present disclosure can diffuse heat through the thermal conductor with a smaller area.

### BRIEF DESCRIPTION OF DRAWINGS

Fig. 1 is a schematic front view of an electronic device according to an embodiment of the present disclosure.
Fig. 2 is a schematic exploded perspective view of a body.
Fig. 3 is a schematic plan view of a display, a thermal conductor, and a double-sided tape piece when viewed from a position facing the display.
Fig. 4 is a schematic bottom view of the display, the thermal conductor, and the double-sided tape piece when viewed from a position facing a housing.
Fig. 5 is a cross-sectional view taken along line V-V in Fig. 3.
Fig. 6 is a schematic cross-sectional view of the housing, a substrate, and a first wiring board taken along an XY cross section at a first opening and a second opening.
Fig. 7 is a schematic cross-sectional view of an electronic device according to another embodiment of the present disclosure taken at a position corresponding to Fig. 5.

### DETAILED DESCRIPTION

Embodiments of the present disclosure will now be described with reference to the drawings. The present invention is not limited to the embodiments. In the drawings, like reference numerals denote substantially the same components. The drawings are schematic and are not drawn to scale relative to the actual size of each component.

For ease of explanation, directional terms such as up, down, and height are used herein to describe the components in typical use. These terms are not intended to limit the use or other situations of an electronic device according to one or more embodiments of the present disclosure.

### (Embodiments)

The structure of an electronic device according to an embodiment of the present disclosure will now be described. The electronic device according to one or more embodiments of the present disclosure is, for example, a gaming device, a smartphone, or a personal computer. In the example described below, the electronic device is, for example, a gaming device.

In the present embodiment, the electronic device is a portable device that is placed on a mount surface, such as a floor or a desktop, or is held by a user when used. The electronic device may perform a gaming process. The gaming process may be performed on a console or a cloud server separate from the electronic device, rather than being performed on the electronic device. In this case, for example, the electronic device displays, on its display, images or videos generated through the process performed on the separate console or cloud server.

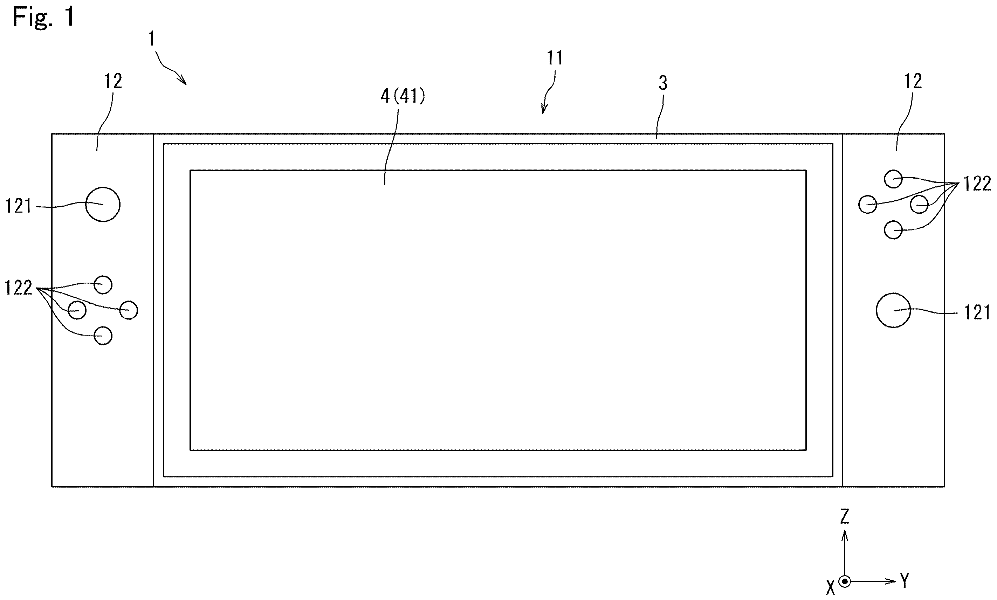

Fig. 1 is a schematic front view of the electronic device according to the embodiment of the present disclosure.

For ease of explanation, an electronic device 1 has a depth direction referred to as the X-direction, a width direction as the Y-direction, and a height direction as the Z-direction herein and in the drawings. The X-direction, the Y-direction, and the Z-direction intersect with one another (orthogonal to one another in the present embodiment). The X-direction, which is the depth direction of the electronic device 1, is an example of a thickness direction. The Y-direction, which is the width direction of the electronic device 1, is an example of an orthogonal direction.

As shown in Fig. 1, the electronic device 1 includes a body 11 and two controllers 12 detachably attached to the body 11. In the present embodiment, the two controllers 12 are attached to the two ends of the body 11 in the Y-direction. The two controllers 12 may be attached to or detached from the body 11 in any known manner, such as fitting, sliding, or with magnets. The electronic device 1 may include any number of controllers 12 other than two. The electronic device 1 may include no controller 12.

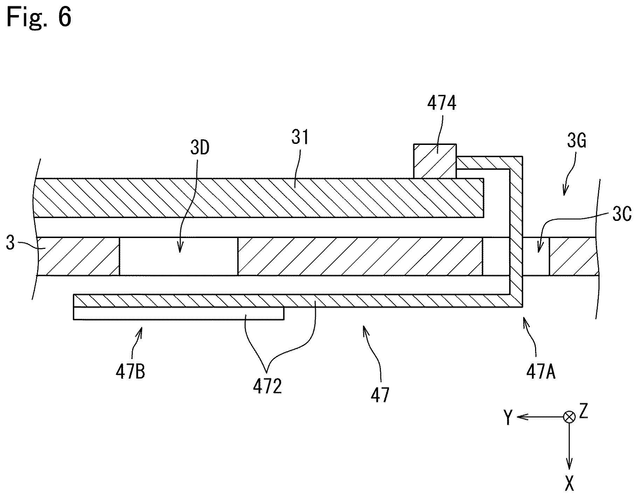

The two controllers 12 are used to operate the electronic device 1. The two controllers 12 may have a wired connection to the body 11 (specifically, to a main board 31 located in an internal space 3G of a housing 3 in the body 11 described later; refer to Fig. 6). In some embodiments, the controllers 12 may allow a remote operation of the electronic device 1 through a network such as the Internet. In this case, multiple users at different locations can play the game performed on the electronic device 1.

Each of the two controllers 12 includes, for example, a stick and operation buttons used for operations. In the present embodiment, each of the two controllers 12 includes a stick 121 and operation buttons 122.

In the present embodiment, the body 11 is a substantially rectangular prism in general. The body 11 may have a shape other than a substantially rectangular prism.

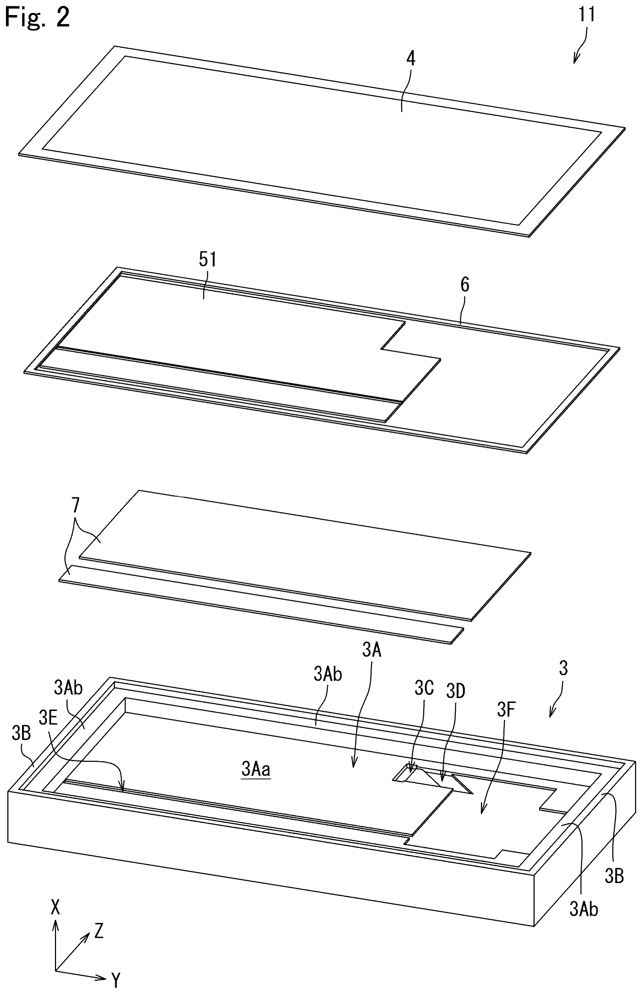

Fig. 2 is a schematic exploded perspective view of the body.

As shown in Fig. 2, the body 11 includes a housing 3, a display 4, a thermal conductor 51, a double-sided tape piece 6, and a pressing sheet 7.

The housing 3 includes the internal space 3G (refer to Fig. 6). The internal space 3G accommodates various components, such as the main board 31.

The housing 3 may be a single member or may be a combination of multiple members.

The housing 3 has a recess 3A. The recess 3A is recessed in the X-direction from an upper surface 3B of the housing 3. The recess 3A includes a bottom surface 3Aa and a step surface 3Ab. The step surface 3Ab surrounds the bottom surface 3Aa when viewed in the X-direction. The step surface 3Ab is located between the upper surface 3B and the bottom surface 3Aa in the X-direction.

The bottom surface 3Aa has a first opening 3C, a second opening 3D, a groove 3E, and a recess 3F. The first opening 3C and the second opening 3D extend, in the X-direction, through one of the outer walls of the housing 3 including the bottom surface 3Aa. Thus, the internal space 3G of the housing 3 (refer to Fig. 6) is continuous with the outside of the housing 3 through the first opening 3C and the second opening 3D. The groove 3E and the recess 3F are recessed from the bottom surface 3Aa in the X-direction. The groove 3E extends in the Y-direction. The recess 3F is continuous with the groove 3E.

The display 4 is received in the recess 3A. The double-sided tape piece 6 is bonded to the step surface 3Ab of the recess 3A. With the double-sided tape piece 6, the outer edge of the display 4 when viewed in the X-direction is bonded to the step surface 3Ab of the recess 3A. The double-sided tape piece 6 is a piece of any known tape. The structure of the display 4 will be described in more detail later.

The thermal conductor 51 diffuses heat. In the present embodiment, the thermal conductor 51 is a graphite sheet. The thermal conductor 51 is located between the housing 3 and the display 4 in the X-direction. The thermal conductor 51 is bonded to the display 4. The thermal conductor 51 is not limited to a graphite sheet and may be any material that diffuses heat. For example, the thermal conductor 51 may be a ceramic sheet. The position at which the thermal conductor 51 is bonded on the display 4 will be described later, along with the detailed structure of the display 4.

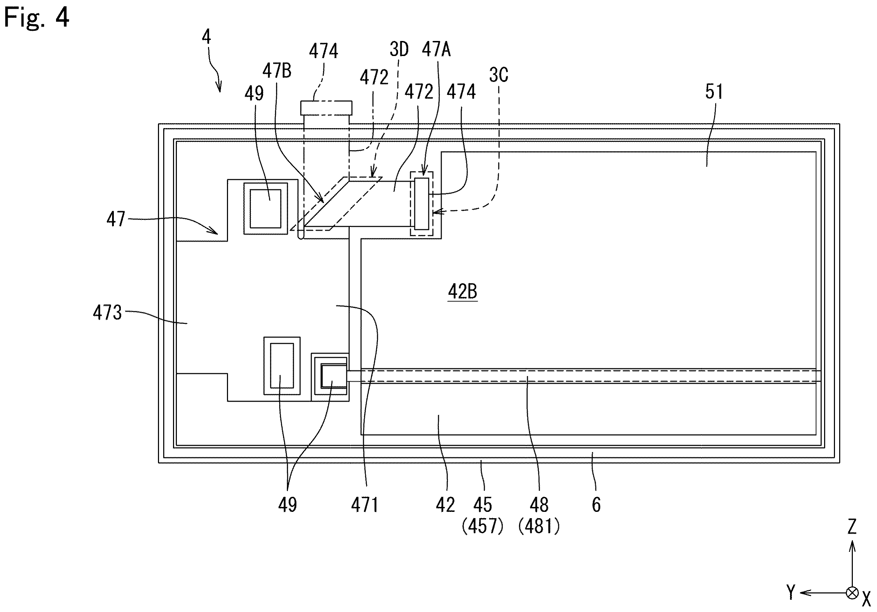

The pressing sheet 7 is bonded to the bottom surface 3Aa of the housing 3. The pressing sheet 7 serves as a cushion for the display 4 received in the recess 3A. The pressing sheet 7 is formed from, for example, polyurethane foam. The pressing sheet 7 does not overlap a first wiring board 47 or a second wiring board 48 (refer to Fig. 4, described later) when viewed in the X-direction.

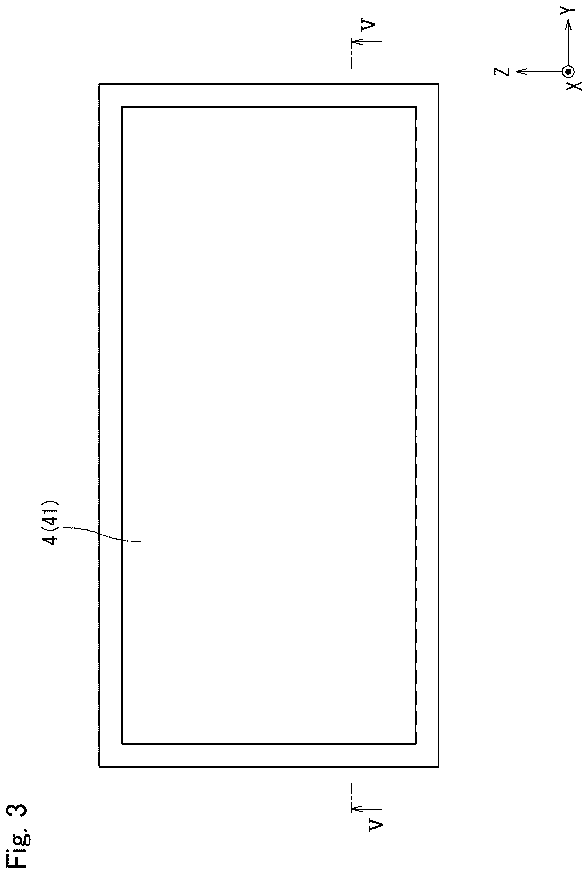

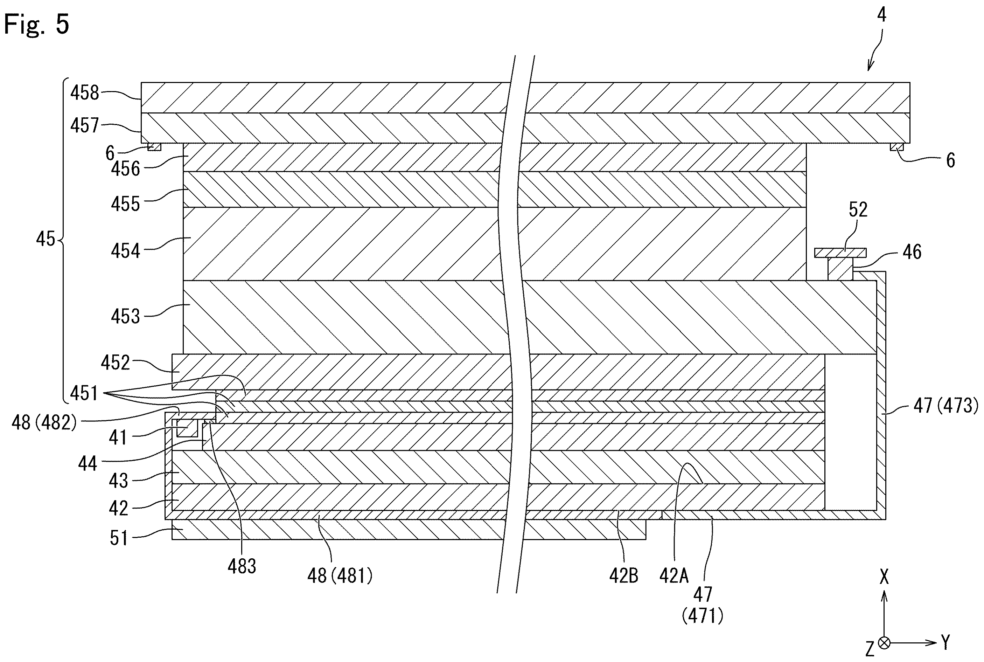

The structure of the display 4 will now be described in detail. Fig. 3 is a schematic plan view of the display, the thermal conductor, and the double-sided tape piece when viewed from a position facing the display. Fig. 4 is a schematic bottom view of the display, the thermal conductor, and the double-sided tape piece when viewed from a position facing the housing. Fig. 5 is a cross-sectional view taken along line V-V in Fig. 3.

As shown in Figs. 3 to 5, the display 4 includes a light source 41, a backplate 42, a reflective plate 43, a light guide plate 44, a liquid crystal panel 45, a driver component 46, the first wiring board 47, the second wiring board 48, and electronic components 49.

As shown in Fig. 5, the backplate 42, the reflective plate 43, the light guide plate 44, and the liquid crystal panel 45 are stacked in this order in the X-direction. In the X-direction, the backplate 42 is closest to the bottom surface 3Aa of the housing 3, and the liquid crystal panel 45 is farthest from the bottom surface 3Aa of the housing 3.

The light source 41 is a light-emitting diode (LED) in the present embodiment. However, the light source 41 is not limited to an LED and may be any known light source.

The light source 41 is adjacent to the light guide plate 44 in the Y-direction. When viewed in the X-direction, the light source 41 is located at an end of the liquid crystal panel 45 in the Y-direction. Multiple light sources 41 are arranged in the Z-direction (in other words, the direction into the page of Fig. 5). Each light source 41 emits light in the Y-direction toward the light guide plate 44.

The backplate 42 is located opposite to the liquid crystal panel 45 in the X-direction with the light guide plate 44 located between the backplate 42 and the liquid crystal panel 45. In the present embodiment, the backplate 42 includes a resin plate surrounded by a metal bezel. The structure of the backplate 42 is not limited to this. For example, the backplate 42 may conversely include a metal plate surrounded by a resin bezel, or may include a metal plate alone.

The reflective plate 43 reflects light.

The light guide plate 44 is located opposite to the housing 3 in the X-direction with the backplate 42 located between the light guide plate 44 and the housing 3. The light guide plate 44 transmits light. For example, the light guide plate 44 is, but not limited to, a translucent acrylic plate.

In the present embodiment, the light source 41 emits light in the Y-direction toward the light guide plate 44, which then diffuses the light. The light guide plate 44 thus emits light from its surface, directing the light in the X-direction toward the liquid crystal panel 45. More specifically, in the present embodiment, the light guide plate 44 redirects light traveling in the Y-direction from the light source 41 to the X-direction, and guides the light to the liquid crystal panel 45. The light source 41, the reflective plate 43, and the light guide plate 44 form a backlight. The light traveling in the direction aligned with the X-direction and opposite to the direction toward the liquid crystal panel 45 is reflected by the reflective plate 43. The light guide plate 44 thus emits light from its two faces in the X-direction.

The liquid crystal panel 45 faces the light guide plate 44 in the X-direction. The liquid crystal panel 45 is illuminated with light from the light source 41 transmitted through the light guide plate 44. The liquid crystal panel 45 includes an optical sheet 451, a first polarizer 452, a first panel 453, a second panel 454, a second polarizer 455, an adhesive 456, a glass cover 457, and an anti-scattering film 458.

The optical sheet 451, the first polarizer 452, the first panel 453, the second panel 454, the second polarizer 455, the adhesive 456, the glass cover 457, and the anti-scattering film 458 are stacked in this order in the X-direction. In the X-direction, the optical sheet 451 is closest to the light guide plate 44, and the anti-scattering film 458 is farthest from the light guide plate 44.

The optical sheet 451 is a single film or a stack of multiple films. Examples of such one or more films include a diffusion film, a brightness enhancement film, a polarization splitting film, a lens film for collecting light, and a phosphor film that allows the representation of a wider range of colors. The optical sheet 451 in the present embodiment includes three of the above films stacked on top of one another.

The first panel 453 and the second panel 454 are sandwiched between the first polarizer 452 and the second polarizer 455.

The first polarizer 452 and the second polarizer 455 transmit light in the X-direction alone. The first polarizer 452 and the second polarizer 455 do not transmit light in directions other than the X-direction (e.g., light in the Y-direction) but absorb such light.

The first panel 453 includes a liquid crystal layer including liquid crystal molecules and a pair of alignment films sandwiching the liquid crystal layer. The pair of alignment films are electrically connected to the driver component 46. The second panel 454 has the same structure as or a similar structure to the first panel 453.

The glass cover 457 protects the liquid crystal panel 45 from external impact. The glass cover 457 is bonded to the second polarizer 455 with the adhesive 456.

The anti-scattering film 458 is bonded to the glass cover 457 to reduce the likelihood that fragments scatter when the glass cover 457 breaks under external impact.

The liquid crystal panel 45 may have any known structure other than the structure described above. For example, the liquid crystal panel 45 may include a single panel, in place of the two panels (the first panel 453 and the second panel 454) in the present embodiment.

The driver component 46 is located on the liquid crystal panel 45. In the present embodiment, the driver component 46 is supported by the first panel 453 in the liquid crystal panel 45. The driver component 46 is electrically connected to the alignment films included in the first panel 453 and the second panel 454. In the present embodiment, a thermal conductor 52 is bonded to the driver component 46. The thermal conductor 52 is, but not limited to, a graphite sheet similar to the thermal conductor 51.

The driver component 46 applies a voltage to each pixel in the first panel 453 and the second panel 454 and also controls the voltage to be applied in response to an instruction from the main board 31 (refer to Fig. 6). The driver component 46 thus controls the display of the liquid crystal panel 45.

When viewed in the X-direction, the driver component 46 is located at the end of the liquid crystal panel 45 in the Y-direction opposite to the light source 41. In other words, the light source 41 is located at one end of the liquid crystal panel 45 in the Y-direction when viewed in the X-direction, and the driver component 46 is located at the other end of the liquid crystal panel 45 in the Y-direction when viewed in the X-direction.

Each of the first wiring board 47 and the second wiring board 48 is a flexible printed circuit board.

The first wiring board 47 is received in the recess 3F on the housing 3 (refer to Fig. 2).

As shown in Fig. 4, the first wiring board 47 includes a mount 471, a first connection 472, and a second connection 473.

The mount 471 has the electronic components 49 mounted on the mount 471. As shown in Figs. 4 and 5, the mount 471 is located on a support surface 42B of the backplate 42 opposite to a surface 42A of the backplate 42 facing the reflective plate 43 in the X-direction. The mount 471 is bonded to the support surface 42B.

As shown in Fig. 4, the first connection 472 extends from the mount 471. The first connection 472 includes a first bend 47A and a second bend 47B. Each of the first bend 47A and the second bend 47B is a bent portion of the first connection 472. The first bend 47A overlaps the first opening 3C when viewed in the X-direction. The second bend 47B overlaps the second opening 3D when viewed in the X-direction. In Fig. 4, the first connection 472 being bent is drawn with solid lines. A first connection 472 not being bent is drawn with two-dot-dash lines.

The first connection 472 extends from the mount 471 in the Z-direction toward the second opening 3D on the support surface 42B. The first connection 472 is bent at the second bend 47B and extends in the Y-direction changed from the Z-direction. More specifically, the first connection 472 is bent at the second bend 47B from the Z-direction along the support surface 42B to the Y-direction along the support surface 42B and intersecting with the Z-direction (orthogonal to the Z-direction in the present embodiment). The Z-direction is an example of a first direction. The Y-direction is an example of a second direction. After changing its direction, the first connection 472 extends in the Y-direction toward the first opening 3C on the support surface 42B. The second bend 47B has a folded-back shape in which the first connection 472 is folded back. In contrast, the first bend 47A has a bent shape, not a folded-back shape. The first connection 472 is folded back by substantially 180 degrees at the second bend 47B in the present embodiment. In contrast, the first connection 472 is bent by substantially 90 degrees at the first bend 47A in the present embodiment.

Fig. 6 is a schematic cross-sectional view of the housing, the substrate, and the first wiring board taken along an XY cross section at the first opening and the second opening.

As shown in Fig. 6, the first connection 472 is bent at the first bend 47A and extends in the X-direction changed from the Y-direction. After changing its direction, the first connection 472 passes through the first opening 3C into the internal space 3G of the housing 3. In other words, the first connection 472 is bent in the X-direction and passes through the first opening 3C. A connector 474 is located at a distal end of the first connection 472 (in other words, one of the two ends of the first connection 472 opposite to the end connected to the mount 471). The connector 474 is electrically connected to the main board 31 in the internal space 3G of the housing 3.

As shown in Fig. 4, the second connection 473 extends from the mount 471 in the Y-direction on the support surface 42B.

As shown in Fig. 5, the second connection 473 is bent from the Y-direction to the X-direction outside the backplate 42 when viewed in the X-direction. After being bent, the second connection 473 extends in the X-direction toward the first panel 453 along the outside of the reflective plate 43, the light guide plate 44, the optical sheet 451, and the first polarizer 452 when viewed in the X-direction. The second connection 473 extending in the X-direction is bent from the X-direction to the Y-direction at a position adjacent to the first panel 453 and is electrically connected to the driver component 46 supported by the first panel 453.

The second wiring board 48 is received in the groove 3E on the housing 3 (refer to Fig. 2). As shown in Fig. 5, the second wiring board 48 includes a first segment 481 and a second segment 482.

As shown in Fig. 4, the first segment 481 is located on the support surface 42B of the backplate 42. The first segment 481 is electrically connected to the mount 471 on the first wiring board 47. The first segment 481 is elongated and extends from the mount 471 in the Y-direction on the support surface 42B. The first segment 481 has no electronic component mounted on the first segment 481.

As shown in Fig. 5, the first segment 481 is bent from the Y-direction to the X-direction outside the backplate 42 when viewed in the X-direction. After being bent, the first segment 481 extends in the X-direction toward the light guide plate 44 along the outside of the reflective plate 43 when viewed in the X-direction. The first segment 481 extending in the X-direction is connected to the second segment 482 at a position adjacent to the light guide plate 44. In the present embodiment, the first segment 481 and the second segment 482 are integral with each other. However, the first segment 481 and the second segment 482 may be separate from each other.

The second segment 482 is adjacent to the light guide plate 44 and the optical sheet 451 in the Y-direction. The light source 41 is mounted on the second segment 482. In other words, the second wiring board 48 is electrically connected to the light source. A portion of the second segment 482 near the position at which the light source 41 is mounted is bonded to the light guide plate 44 with a double-sided tape piece 483. In the present embodiment, the double-sided tape piece 483 is transparent. This reduces uneven color of light passing through the light guide plate 44. For example, the chromaticity is lower than when the double-sided tape piece 483 is white. In particular, the x value, of the x and y values of chromaticity in the XYZ color system, has a much lower chromaticity.

As described above, the first wiring board 47 is electrically connected to the main board 31, and the second wiring board 48 is electrically connected to the first wiring board 47. The main board 31 includes an arithmetic unit to control the operation of the electronic device 1. The driver component 46 controls the display of the liquid crystal panel 45 in response to an instruction from the main board 31, as described above. The light source 41 is turned on or off in response to an instruction from the main board 31 or the driver component 46.

As shown in Fig. 4, the thermal conductor 51 is bonded to the support surface 42B of the backplate 42 and covers at least part of the second wiring board 48 on the support surface 42B. In the present embodiment, the thermal conductor 51 is bonded to a portion of the second wiring board 48 on the support surface 42B other than a portion near the first wiring board 47. In other words, the thermal conductor 51 in the present embodiment covers part of the second wiring board 48 on the support surface 42B. The thermal conductor 51 may cover the entire second wiring board 48 on the support surface 42B.

The thermal conductor 51 at least does not cover part of the first wiring board 47 on the support surface 42B. In other words, at least part of the first wiring board 47 is exposed without being covered with the thermal conductor 51. In the present embodiment, the thermal conductor 51 covers no part of the first wiring board 47. In other words, the entire first wiring board 47 is exposed without being covered with the thermal conductor 51 in the present embodiment. The thermal conductor 51 may cover part of the first wiring board 47 on the support surface 42B, with the other part of the first wiring board 47 being uncovered.

As shown in Fig. 5, the thermal conductor 51 overlaps the light source 41 when viewed in the X-direction. In the present embodiment, the thermal conductor 51 overlaps the entire light source 41 when viewed in the X-direction. However, the thermal conductor 51 may overlap part of the light source 41.

### (Other Embodiments)

In the above embodiment, the light source 41 is adjacent to the light guide plate 44 in the Y-direction. The light source 41 is located at the end of the liquid crystal panel 45 in the Y-direction when viewed in the X-direction. The light guide plate 44 redirects light traveling in the Y-direction from the light source 41 to the X-direction, and guides the light to the liquid crystal panel 45. In other words, the backlight including the light source 41, the reflective plate 43, and the light guide plate 44 is an edge-lit backlight in the above embodiment. However, the backlight is not limited to an edge-lit backlight.

For example, the light guide plate 44 may be replaced by a diffuser that diffuses light emitted in the X-direction from the light source 41 and guides the light to the liquid crystal panel 45. The light source 41 may be located opposite to the liquid crystal panel 45 in the X-direction with the diffuser located between the light source 41 and the liquid crystal panel 45. In other words, the light guide plate may be replaced by a diffuser that diffuses light from the light source and guides the light to the liquid crystal panel. The light source may be located opposite to the liquid crystal panel in the thickness direction with the diffuser located between the light source and the liquid crystal panel. More specifically, the backlight may be a direct backlight.

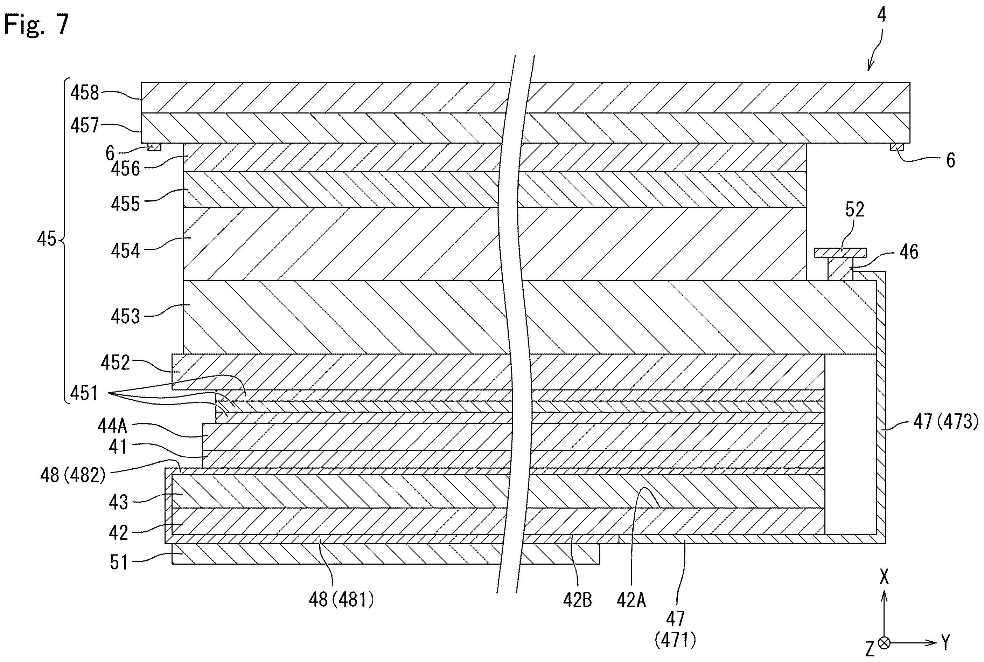

Fig. 7 is a schematic cross-sectional view of an electronic device according to another embodiment of the present disclosure taken at a position corresponding to Fig. 5.

In the electronic device according to the other embodiment, as shown in Fig. 7, the light source 41 is located between the diffuser 44A and the reflective plate 43 in the X-direction. Multiple light sources 41 are arranged in the Y-direction and the Z-direction. In other words, the multiple light sources 41 are arranged in a YZ plane. Each light source 41 emits light toward the diffuser 44A.

The electronic device according to the other embodiment includes the diffuser 44A in place of the light guide plate 44. For example, the diffuser 44A included in the electronic device according to the other embodiment has fine irregularities on its surface. The irregularities scatter incident light in multiple directions, thus diffusing light. Such irregularities may be included in the light guide plate 44 shown in Fig. 5.

The embodiments or modifications described above may be combined with one another as appropriate to produce their advantageous effects.

### EXPLANATION OF REFERENCES

- 1: electronic device

- 3: housing
- 3C: first opening
- 3D: second opening
- 41: light source
- 42: backplate
- 42B: support surface
- 44: light guide plate
- 45: liquid crystal panel
- 46: driver component
- 47: first wiring board
- 47A: first bend
- 47B: second bend
- 48: second wiring board
- 49: electronic component
- 51: thermal conductor

## Claims

1. An electronic device (1), comprising:
a light guide plate (44);
a light source (41) configured to emit light toward the light guide plate (44);
a liquid crystal panel (45) facing the light guide plate (44) in a thickness direction and configured to be illuminated with light from the light source (41) transmitted through the light guide plate (44);
a backplate (42) located opposite to the liquid crystal panel (45) in the thickness direction with the light guide plate (44) located between the backplate (42) and the liquid crystal panel (45);
a driver component (46) located on the liquid crystal panel (45) to control display of the liquid crystal panel (45);
a first wiring board (47) located on a support surface (42B) of the backplate (42) and electrically connected to the driver component (46), the support surface (42B) being opposite to a surface of the backplate (42) facing the light guide plate (44) in the thickness direction;
a second wiring board (48) located on the support surface (42B) of the backplate (42) and electrically connected to the light source (41) and the first wiring board (47); and
a thermal conductor (51) located on the support surface (42B) of the backplate (42) and covering at least part of the second wiring board (48),
wherein at least part of the first wiring board (47) is exposed without being covered with the thermal conductor (51).

2. The electronic device (1) according to claim 1, wherein
the thermal conductor (51) overlaps at least part of the light source (41) when viewed in the thickness direction.

3. The electronic device (1) according to claim 1 or claim 2, wherein the thermal conductor (51) covers no part of the first wiring board (47).

4. The electronic device (1) according to any one of claims 1 to 3, wherein
the light source (41) is adjacent to the light guide plate (44) in an orthogonal direction orthogonal to the thickness direction, and is located at an end of the liquid crystal panel (45) in the orthogonal direction when viewed in the thickness direction, and
the light guide plate (44) redirects light traveling in the orthogonal direction from the light source (41) to the thickness direction, and guides the light to the liquid crystal panel (45).

5. The electronic device (1) according to claim 4, wherein
the light source (41) is located at the end of the liquid crystal panel (45) in the orthogonal direction when viewed in the thickness direction, and
the driver component (46) is located at another end of the liquid crystal panel (45) in the orthogonal direction when viewed in the thickness direction.

6. The electronic device (1) according to any one of claims 1 to 5, wherein
the thermal conductor (51) is a graphite sheet.

7. The electronic device (1) according to any one of claims 1 to 6, wherein
the first wiring board (47) on the support surface (42B) has an electronic component (49) mounted on the first wiring board (47), and
the second wiring board (48) on the support surface (42B) has no electronic component (49) mounted on the second wiring board (48).

8. The electronic device (1) according to any one of claims 1 to 7, wherein
the second wiring board (48) on the support surface (42B) is elongated and extends along the support surface (42B) of the backplate (42).

9. The electronic device (1) according to any one of claims 1 to 8, further comprising:
a housing (3) located opposite to the light guide plate (44) in the thickness direction with the backplate (42) located between the housing (3) and the light guide plate (44),
wherein the housing (3) has a first opening (3C) extending through the housing (3) in the thickness direction, and
the first wiring board (47) includes a first bend (47A) bent in the thickness direction and passing through the first opening (3C).

10. The electronic device (1) according to any one of claims 1 to 9, further comprising:
a housing (3) located opposite to the light guide plate (44) in the thickness direction with the backplate (42) located between the housing (3) and the light guide plate (44),
wherein the housing (3) has a second opening (3D) extending through the housing (3) in the thickness direction,
the first wiring board (47) includes a second bend (47B) bent from a first direction to a second direction, the first direction is along the support surface (42B) of the backplate (42), and the second direction is along the support surface (42B) of the backplate (42) and intersects with the first direction, and
the second bend (47B) overlaps the second opening (3D) when viewed in the thickness direction.
